# EUROPEAN PATENT APPLICATION

(11) **EP 2 818 993 A1**
(43) Date of publication of application: **31.12.2014**
(21) Application number: 13768066.6
(22) Date of filing: 14.03.2013
(51) Int. Cl.: G06F 3/044

(54) **NOVEL ITO CROSSOVER INTEGRATED CAPACITIVE TOUCH SCREEN AND MANUFACTURING METHOD THEREOF**

(30) Priority: 27.03.2012 CN 201210084785
(71) Applicant: Shenzhen Baoming Technology Ltd, Guangdong 518000 (CN)
(72) Inventor: CAO, Xiaoxing, Shenzhen Guangdong 518000 (CN)
(74) Representative: Sun, Yiming
(86) International application number: PCT/CN2013/072592
(87) International publication number: WO 2013/143397

(57) **Abstract**

Disclosed are a novel ITO crossover integrated capacitive touch screen and a manufacturing method thereof. The novel ITO crossover integrated capacitive touch screen comprises a transparent substrate, and a silicon dioxide layer, a niobium pentoxide layer, a black resin layer, an ITO crossover electrode, a first insulation layer, an ITO electrode, a metal electrode, and a second insulation layer sequentially stacked on the transparent substrate. The silicon dioxide layer covers the glass completely, and the niobium pentoxide layer covers the silicon dioxide layer completely. The ITO electrode comprises a capacitive screen driver and a sensing electrode, and is provided with a patterned graphic structure. The capacitive screen driver and the sensing electrode are on the same layer, mutually independent, mutually insulated, and vertical in design. By the reasonable design for the stacked structure and the crossover conductive mode of the capacitive touch screen, the present invention can effectively improve the transmittance of the capacitive touch screen and reduce the visibility of the ITO pattern, and the reliability of the touch screen is further improved. novel ITO crossover integrated capacitive touch screen.

## Description

### Field of Invention

The present invention relates to the technological field of capacitive touch screen, more particularly to a single-body capacitive touch screen designed with ITO crossover structure and manufacturing method thereof.

### Background of Invention

With the development of electronic technology, keyboards or mice once used in mobile phone, digital camera, handheld game player, vehicle DVD player, MP3 and instrument and apparatus have been gradually replaced by touch screens. Just years ago, touch screens were not so popular in the market. However, with the increasing number of consumers who use the products, touch screens began to be accepted by more people and the related technology grows faster than ever. The speedy growth of touch screen products not only spark fiercer competition in the industry, but also indirectly promote the upgrading of the related technologies. Especially, the operation mode of multi-point control spreads the influence of touch screens in the market to a higher dimension, and attracts more attention from people.

Basically, a touch screen consists of two parts-detector and controller. The former, installed in front of the monitor screen, is used to detect the position of user's touch and send the signals to the latter, while the latter accepts the signals from the detector, converts them into coordinates of the contacting point and then send them to CPU. In the meantime, the controller also receives commands from CPU and executes them.

According to the operating principle of touch screen and the medium that transmits signals, touch screens fall into four categories: resistive type, capacitive induction type, infrared type and SAW (surface acoustic wave) type. The resistive touch screen, most widely used so far, performs resistance control by taking the advantage of the forced induction. A resistive touch screen is a multi-layer composite film, whose main part is the resistive film panel perfectly matching the monitor. The resistive film panel uses a glass or hard plastic panel as its substrate, the surface of which is coated with a conductive layer -the transparent oxide metal (transparent conductive resistor) ITO (indium tin oxide). Covered on the surface of the conductive layer is a smooth and scratch-proof plastic layer that has undergone hardening treatment, the internal surface of which is also coated with an ITO layer. Between the two ITO layers are a great number of small transparent isolation spots (size less than 1/1000 inch) that isolate the two ITO layers. Once the user's finger touches the screen, the isolation spots will be contacting each other, while the resistance will change and signals will be generated at both direction X and Y. These signals are then transmitted to the controller that detects this contact and computes the locations of X and Y. After that, the system will operate like a simulated mouse.

A capacitive touch screen works by making use of the current induction on human body, which comprises of two composite glass panels. Coated on the internal surface of the glass panel is a conductive film-the ITO layer, while its external surface is coated with protective thin silica layer. The ITP layer functions as a working face, whose four corners lead out four electrodes. Once the user's finger touches the screen, because of the human electric field, a coupling capacitance will be formed between the user and the surface of touch screen. As for high-frequency current, the capacitance will serve as a direct conductor. Thus, the user's finger absorbs from the contact a very low current which comes from the four corners of the touch screen respectively and is in direct proportion to the distance between the finger and the four corners. The controller will tell the location of contact through precise computation of the four current ratios.

Among the capacitive touch screens, the most widely used is the projected capacitive touch screen, which features its simple structure and high light transmittance. The touch-sensing part of a projected capacitive touch screen is an induction matrix structured by interlacing multiple row and column electrodes. Normally, in designing the touch screen, the row and column electrodes are respectively set at the two sides of the same transparent substrate, so as to avoid short circuit at the interlacing positions, or they are set at the same side of one transparente substrate and stand on the same the conductive film (often ITO conductive film). In the second structure, insulation layer and conducting bridge are used at the interlacing locations of the electrodes, so that the row electrodes and column electrodes are separated from each other to ensure conductivity for their respective direction. In this way, short circuit can be prevented at the positions of interlacing.

In normal designing, one type of the electrodes (either row or column electrodes) is continuously set on the conductive film, while the other forms several electrode blocks on the conductive film after partitioned by the continuously set electrodes. At the interlacing positions the neighboring electrodes are connected through the conductive bridge, thus forming continuous electrodes in the other direction. The conductive bridge and the continuously set electrodes are separated by the insulation layer, so that short circuit can be prevented at the interlacing positions of the row or column electrodes. The commonly used designed scheme is: (1) The laminated structure sequentially consists of transparent substrate, first direction electrode, insulation layer and conducting bridge; or (2) The laminated structure sequentially consists of transparent substrate, conducting bridge, insulation layer and first direction electrode.

In capacitive touch screen with conventional design such defects as lower light transmittance and poor operating stability always exist. Conventional design seldom offers light transmittance higher than 80%. Besides, when the whole structure deforms because of abnormal force, the interface will be detached, which may result in ineffective touch because of the open circuit of electrode, and in damage of the touch sensor.

### Summary of Invention

The first object of the present invention is to provide A novel ITO crossover integrated capacitive touch screen. Through improved design with its laminated structure and bridged conduction, the transmittance of the touch screen can be efficiently improved, visuality of ITO pattern lowered and reliability of the touch screen enhanced.

To achieve the aforesaid object, the present invention will adopt the technical scheme below:
The novel ITO crossover integrated capacitive touch screen includes the transparent substrate, and the silica layer, niobium pentoxide layer, black resin layer, ITO crossover electrode, first insulation layer, ITO electrode, metal electrode and second insulation layer that are sequentially laminated on the transparent substrate. The said ITO electrode consists of capacitive screen driver (ITO electrode 1) and inductive electrode (ITO electrode 2), with regularly patterned structure. ITO electrode 1 and 2 are vertically designed on the same layer, but mutually independent and insulative. The said transparent substrate comprises of window section and non-window section, with the black resin arranged in the non-window section of the display screen. The said silica layer is 100-1000 ANG in thickness, while niobium pentoxide layer is 50-500 ANG. The wiring of the said metal electrode is only arranged in the black resin section, and no metal electrode is set in the window section.

The aforesaid novel ITO crossover single-body capacitive touch screen can also be structured as follows: the transparent substrate, and the black resin layer, silica layer, niobium pentoxide layer, ITO crossover electrode, first insulation layer, ITO electrode, metal electrode and second insulation layer that are sequentially laminated on the transparent substrate. The said ITO electrode consists of capacitive screen driver (ITO electrode 1) and inductive electrode (ITO electrode 2), with regularly patterned structure. ITO electrode 1 and 2 are vertically designed on the same layer, but mutually independent and insulative. The said transparent substrate comprises of window section and non-window section, while the black resin distributed in the non-window section of the display screen. The said silica layer is 100-1000 ANG in thickness, while niobium pentoxide layer is 50-500 ANG. The wiring of the said metal electrode is only arranged in the black resin section, and no metal electrode is set in the window section.

The optimized selections for this model are as follows: The said transparent substrate is made of chemically tempered glass, or resin, with thickness of 0.5-2.0mm, and the said ITO electrode is structured as regularly patterned rhombus, bar, square, snowflake or cross.

The said black resin layer can shade not only the graphics layer of non-window section, but also the light and the visible things under the metal wire. ITO crossover electrode includes crossover electrode 1 at the window section of the display screen and the crossover electrode 2 at the edge of the black resin layer, both with regularly patterned structure. Crossover electrode 1 is connected to the drive wire of ITO electrode (right and left ends of ITO electrode1) and induction wire (upper and lower ends of ITO electrode 2-not shown in the drawing). And crossover electrode 2 is connected to metal electrode and the drive wire (ITO electrode 1) or induction wire (ITO electrode 2) of ITO electrode, and prevents both of them from breaking at the slope of the black resin layer. The first insulation layer insulates ITO electrode 1 and 2 to keep them from being conducted to each other. The bonding area of the flexible PCB with ITO electrode signal conduction is created through the metal electrode. The second insulation layer protects the metal electrode and ITO conductor and keeps them insulated from the air.

The second object of the present invention is to provide a method to manufacture the novel ITO crossover integrated capacitive touch screen and the technical scheme below is adopted:
Formation of silica layer: Coat the transparent substrate with SiO₂ to form a transparent SiO₂ film with even thickness of 100-1000 ANG;
Formation of niobium pentoxide layer: Coat the silica layer with Nb₂O₅ to form a transparent Nb₂O₅ film with even thickness of 50-500 ANG;
Formation of black resin layer: First the black resin is evenly spread to the transparent substrate by spin-coating or blade-coating, with thickness of 0.3µm~5µm. Then the resin is pre-baked, exposed and developed to create the needed black-resin section. The black-resin section is structured as trapezoid, with thickness of 0.3µm~5µm in its middle and a bevel angle of 6-60 degrees at the edge. Such a gentle angle is designed in an attempt to prevent the ITO electrode from breaking in the case of the sharp thickness difference appearing when ITO electrodes (drive wire ITO electrode 1 and induction wire ITO electrode 2) pass by the slope. The black resin area serves as the non-window section of the display screen to shade the metal electrode. The said black resin is made of protective light-sensitive photoresist (KE410 made by Taiwan Everlight Chemical). As a black negative photoresist, the material mainly consists of: acryl resin, epoxy resin, negative light-sensitive agent, propylene glyool monomethyl ether acetate(PMA) and black pigment, the actual ratio of which are as follows: 15~30(resin):60~80(PMA):1~10(black pigment and negative light-sensitive agent). Formation of ITO crossover electrode: Use ITO to coat the black resin-coated transparent substrate and make a transparent ITO film with even thickness of 50-2000ANG on the substrate (surface resistance 10-430 ohm);
Coat a layer of positive photoresist on the ITO-coated transparent substrate, with even thickness of 1µm~5µm;
After the photoresist is pre-baked, exposed, developed, etched and released, and finally a 50-200ANG-thick layer of photoresist (surface resistance 10-430ohm) and the regular ITO pattern or electrode will be formed.

The said ITO crossover electrodes include the crossover electrode in the display screen and overlapping electrode at the edge of the black-resin layer, both of which have regularly patterned structure, and are designed on the same layer and mutually independent and insulative.

### Formation of first insulation layer:

Coat a layer of negative photoresist on the ITO-coated transparent substrate, with even thickness of 0.5µm~3µm;
After the photoresist is pre-baked, exposed and developed, the insulation layer pattern with thickness of 0.5~3µm will be formed (pattern can be shaped rectangular, square, rhombus, ellipse and so on).

### Formation of ITO electrode layer:

Coat a transparent ITO film on the transparent substrate with first insulation layer, with even thickness of 50-2000ANG (surface resistance 10-430 ohm);
Coat a layer of positive photoresist on the ITO-coated transparent substrate, with even thickness of 1µm~5µm;
After the photoresist is pre-baked, exposed, developed, etched and released, and finally a 50-200ANG-thick layer of photoresist (surface resistance 10-430ohm) and the regular ITO pattern or electrode will be formed.

The said ITO electrodes includes the driver (ITO electrode 1) in the capacitive screen and induction electrode (ITO electrode 2), both of which have regularly patterned structure, and are vertically designed on the same layer and mutually independent and insulative.

Conduction of ITO electrode 1 is realized after it forms a drive pathway through its overlapped joint. To realize the conduction of ITO electrode 2, ITO itself ascends from the bottom of the first insulation layer to the top, and descends from the top to the bottom, and then an induction pathway can be formed.

### Formation of metal electrode layer:

Coat a metal film on the transparent substrate with ITO electrode layer, with even thickness of 500-4000ANG;

Coat a layer of positive photoresist on the metal-coated transparent substrate, with even thickness of 1µm~5µm;
After the photoresist is pre-baked, exposed, developed, etched and released, and finally a 500-4000ANG-thick layer of photoresist (surface resistance 10-430ohm) and the regular ITO pattern or electrode will be formed.

### Formation of second insulation layer:

Coat a layer of negative photoresist on the metal-coated transparent substrate, with even thickness of 0.5µm~3µm;
After the photoresist is pre-baked, exposed and developed, the insulation layer pattern with thickness of 0.5~3µm will be formed

The optimized selections for this model are as follows: The said transparent substrate is made of chemically tempered glass, with thickness of 0.5-2.0mm, and the said ITO electrode is made of In₂O₃ and SnO₂, whose mass ratio is 85-95:5-15. ITO coating can be performed through the means below: vacuum magnetic-enhanced sputtering, chemical vapor phase depositing, thermal evaporating and sol-gel method.

The said positive photresist materials are mainly made up of propylene glyool monomethyl ether acetate, epoxy resin and positive light-sensitive agent (TR400 made by Taiwan Xinyingcai Co.); the negative photresist materials are mainly made up of propylene glyool monomethyl ether acetate, acryl resin, epoxy resin and negative light-sensitive agent (POC A46 made by Taiwan Daxing Co.). The photoresist can be coated to the substrate by roll coating, spin coating, blade coating or other ways.

The coated metal film is sandwich structured with stacked MoNb, AlNd and MoNb, whose thickness is respectively arranged as 50-500ANG: 500-3000ANG:50-500ANG. In MoNb alloy, the mass ratio of Mo and Nb is 85-95:5-15, while in AlNd alloy, the mass ratio of Al and Nd is 95∼98:2∼5. The metal material can also be silver alloy or copper alloy compounded under a certain proportion. The process of vacuum magnetic-enhanced sputtering is employed here to make the metal film.

Or conventional technique can be adopted:
Formation of black resin: Spread the black resin on the transparent substrate through spin coating or blade coating with an even thickness of 0.3µm~5µm. After pre-baked, exposed and developed, a required black resin section can be formed.
Formation of silica layer: Coat the transparent substrate with SiO₂ to form a transparent SiO₂ film with even thickness of 100-1000 ANG;
Formation of niobium pentoxide layer: Coat the silica layer with Nb₂O₅ to form a transparent Nb₂O₅ film with even thickness of 50-500 ANG;

The said black resin is made of protective light-sensitive photoresist (KE410 made by Taiwan Everlight Chemical). As a black negative photoresist, the material mainly consists of: acryl resin, epoxy resin, negative light-sensitive agent, propylene glyool monomethyl ether acetate(PMA) and black pigment, the actual ratio of which are as follows: 15~30(resin):60~80(PMA):1~10(black pigment and negative light-sensitive agent).

Formation of ITO crossover electrode: Use ITO to coat the black resin-coated transparent substrate and make a transparent ITO film with even thickness of 50-2000ANG on the substrate (surface resistance 10-430 ohm);

Coat a layer of positive photoresist on the ITO-coated transparent substrate, with even thickness of 1µm~5µm;

After the photoresist is pre-baked, exposed, developed, etched and released, and finally a 50-2000ANG-thick layer of photoresist (surface resistance 10-430ohm) and the regular ITO pattern or electrode will be formed.

The said ITO crossover electrodes include the crossover electrode in the display screen and overlapping electrode at the edge of the black-resin layer, both of which have regularly patterned structure, and are designed on the same layer and mutually independent and insulative.

### Formation of first insulation layer:

Coat a layer of negative photoresist on the ITO-coated transparent substrate, with even thickness of 0.5µm~3µm;
After the photoresist is pre-baked, exposed and developed, the insulation layer pattern with thickness of 0.5~3µm will be formed (pattern can be shaped as rectangular, square, rhombus, ellipse and so on).

### Formation of ITO electrode layer:

Coat the transparent substrate with first insulation layer with a transparent ITO film, which has a even thickness of 50-2000ANG (surface resistance 10-430 ohm);
Coat a layer of positive photoresist on the ITO-coated transparent substrate, with even thickness of 1µm~5µm;
After the photoresist is pre-baked, exposed, developed, etched and released, and finally a 50-2000ANG-thick layer of photoresist (surface resistance 10-430ohm) and the regular ITO pattern or electrode will be formed.

The said ITO electrodes includes the driver electrode (ITO electrode 1) in the capacitive screen and induction electrode (ITO electrode 2), both of which have regularly patterned structure, and are vertically designed on the same layer and mutually independent and insulative.

Conduction of ITO electrode 1 is realized after it forms a drive pathway through its overlapped joint at both left and right. To realize the conduction of ITO electrode 2, ITO itself ascends from the bottom of the first insulation layer to the top, and descends from the top to the bottom, and then an induction pathway can be formed.

### Formation of metal electrode layer:

Coat a metal film on the transparent substrate with ITO electrode layer, with even thickness of 500-4000ANG.

Coat a layer of positive photoresist on the metal-coated transparent substrate, with even thickness of 1µm~5µm;
After the photoresist is pre-baked, exposed, developed, etched and released, and finally a 500-4000ANG-thick layer of photoresist and the regular ITO pattern or electrode will be formed.

### Formation of second insulation layer:

Coat a layer of negative photoresist on the metal-coated transparent substrate, with even thickness of 0.5µm~3µm;
After the photoresist is pre-baked, exposed and developed, the insulation layer pattern with thickness of 0.5~3µm will be formed.

Compared with the prior art, the present invention features its advantages and effects below:
Through improved design of the laminated structure, the touch screen signal electrode and black-resin covering layer can be formed on the transparent substrate, and the sequence and pattern of ITO crossover electrodes optimized, raising the non-defect rate of products, lowering costs and improving products' reliability. Substrate with thickness of 0.5mm~2.0mm in the present invention offers such advantages as thin structure and light mass. The improved design for all layers also features its higher transmittance of capacitive touchscreen and lower visuality of ITO pattern, thus enhancing the reliability of touch screen.

With adopted structure of ITO crossover in this design, the metal crossover point can't be seen in the window section in the display screen, which greatly raises the transmittance of the products.

### Drawings for the present invention

Fig. 1 Structural Diagram of ITO Crossover Capacitive Touch screen;
Fig.2 Structure Diagram of Glass Substrate
Fig. 3 Enlarged Structural Diagram of ITO Crossover Design
Fig. 4 Sectional View for ITO Crossover Structure
Fig.5 Sectional View of Single-body ITO Crossover Capacitive Touch screen
Fig. 6 Diagram of Transmittance Comparison Test Results for Preferred Embodiment
Fig. 7 Diagram of Visuality Comparison Test Results for Preferred Embodiment

### Detailed description of preferred embodiments of the invention

In the following parts are further descriptions of the present invention with reference to the preferred embodiments.

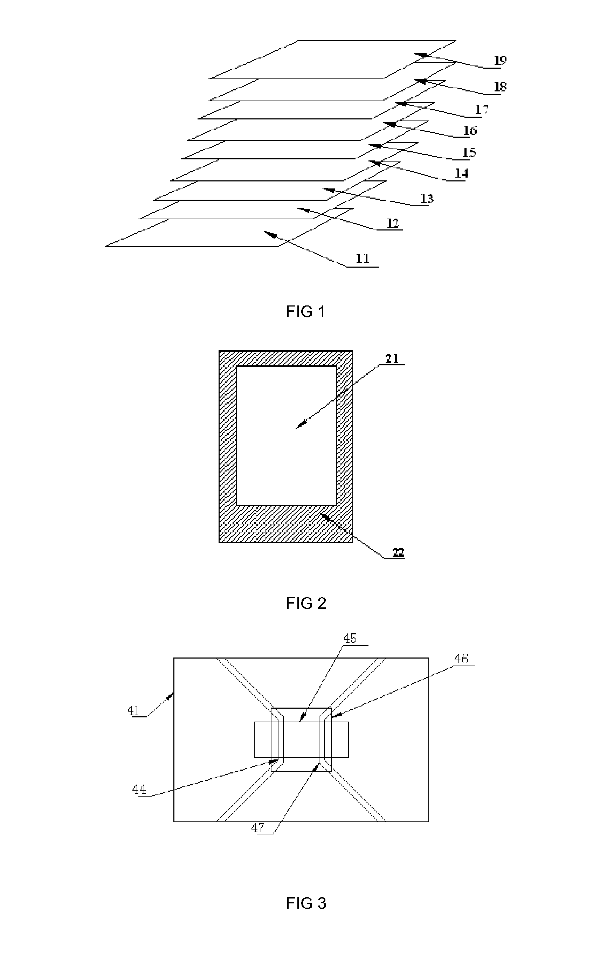

As shown in Fig. 1 and 2, the said ITP crossover capacitive touch screen comprises of the chemically tempered glass substrate or resin substrate (thickness 0.5mm~2.0mm) 11, and of the silica layer12, niobium pentoxide layer13, black resin layer14, ITO crossover electrode15, first insulation layer16, ITO electrode17, metal electrode 18and second insulation layer19 that are sequentially laminated on the transparent substrate. The said ITO crossover electrodes 15 include the crossover electrode in the display screen and overlapping electrode at the edge of the black-resin layer, both of which have regularly patterned structure, and can be shaped as rhombus, bar, square, snowflake or cross.

The said transparent substrate comprises of window section 21 and non-window section 22, with the black resin arranged in the non-window section 22 of the display screen.

The said black resin layer can shade not only the graphics layer of non-window section, but also the light and the visible things under the metal wire.

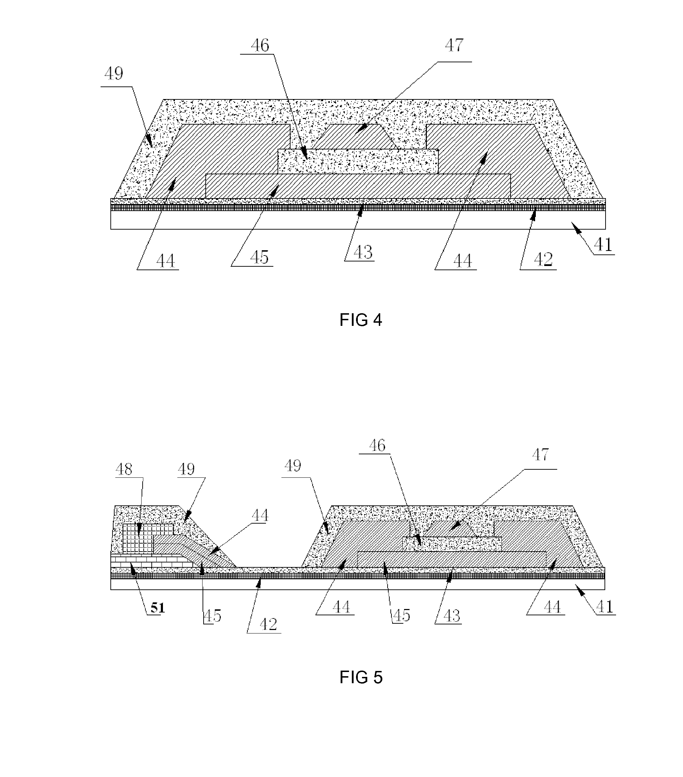

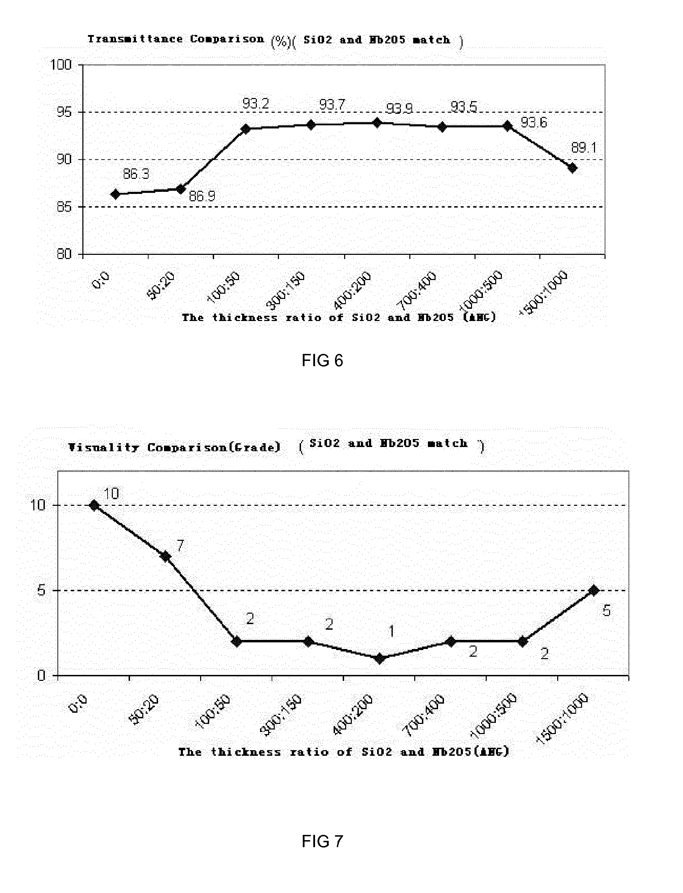

Fig.3-6 are the enlarged diagram for local structure of and sectional view of the said ITO crossover capacitive touch screen of the preferred embodiment: ITO crossover electrode 45 includes crossover electrode 1 at the window section of the display screen and the crossover electrode 2 at the edge of the black resin layer 51, both of which have regularly patterned structure, and can be shaped as rhombus, bar, square, snowflake or cross. Crossover electrode 1 is connected to the drive wire 44 of ITO electrode 17 (right and left ends of ITO electrode1) and induction wire 47(upper and lower ends of ITO electrode 2-not shown in the drawing). And crossover electrode 2 is connected to metal electrode 48 and the ITO electrode's drive wire 44 (ITO electrode 1) or induction wire 47 (ITO electrode 2) of ITO electrode, and prevents both of them from breaking at the slope of the black resin layer 51. The first insulation layer 46 insulates the ITO electrode's drive wire 44(ITO electrode 1) and induction wire 47 (ITO electrode 2) to keep them from being conducted to each other. The bonding of the flexible PCB with ITO electrode signal conduction is realized through the metal electrode. The second insulation layer 49 protects the metal electrode 48 and ITO conductor and keeps them insulated from the air.

### Manufacturing process:

Formation of silica layer: Coat the transparent substrate with SiO₂ to form a transparent SiO₂ film with even thickness of 0, 50, 100, 300, 400, 700, 1000 or 1500 ANG;
Formation of niobium pentoxide layer: Coat the silica layer with Nb₂O₅ to form a transparent Nb₂O₅ film with even thickness of 0, 20, 50, 150, 200, 400, 500 or 1000ANG;

First black resin is evenly spread to the transparent substrate 41(11) by spin-coating or blade-coating, with thickness of 0.3µm~5µm. Then the resin is pre-baked, exposed and developed to create the needed black-resin section. The black-resin section is structured as trapezoid, with thickness of 0.3µm~5µm in its middle and a bevel angle of 6-60 degrees at the edge. Such a gentle angle is designed in an attempt to prevent the ITO electrode from breaking in the case of the sharp thickness difference when ITO electrodes (drive wire ITO electrode 1 and induction wire ITO electrode 2) pass by the slope. The black resin area serves as the non-window section of the display screen to shade the metal electrode. The said black resin is made of protective light-sensitive photoresist (KE410 made by Taiwan Everlight Chemical). As a black negative photoresist, the material mainly consists of: acryl resin, epoxy resin, negative light-sensitive agent, propylene glyool monomethyl ether acetate(PMA) and black pigment, the actual ratio of which are as follows: 15~30(resin):60~80(PMA):1~10(black pigment and negative light-sensitive agent).

In forming the black resin layer, the pre-baking temperature is set as 60-150 °C, time as 50-200 seconds and exposure energy as 100-500mj. Na series or Ka series alkaline solution is used as developer, and developing temperature is set as 20-40 °C. Then the black resin is hard baked under the temperature of 200-300 °Cand for 0.5-3 hours. After the above processes, a black resin layer 51 (12) with regular pattern and thickness of 0.3µm~5µm will be finally formed.

Formation of ITO crossover electrode: After the transparent glass substrate is chemically tempered, it will be ITO coated to make a transparent ITO film with even thickness of 50-2000ANG (surface resistance 10-430 ohm); the said ITO electrode is made of In₂O₃ and SnO₂, whose mass ratio is 85∼95:5∼15. ITO coating can be performed through the means below: vacuum magnetic-enhanced sputtering, chemical vapor phase depositing, thermal evaporating and sol-gel method.

Coat a layer of positive photoresist on the ITO-coated transparent substrate, with even thickness of 1µm~5µm; the said positive photresist materials are mainly made up of propylene glyool monomethyl ether acetate, epoxy resin and positive light-sensitive material. The photoresist can be coated to the substrate by roll coating, spin coating, blade coating or other ways.

After the above processes, the photoresist will be pre-baked, exposed, developed, etched and released, and finally a 50-2000ANG-thick layer of photoresist (surface resistance 10-430ohm) and the regular ITO pattern or electrode will be formed. In forming the layer, the pre-baking temperature is set as 60-150 °C, time as 50-200 seconds and exposure energy as 100-500mj. Na series or Ka series alkaline solution is used as developer, and the developing temperature is set as 20-40 °C. Hydrochloric acid and nitric acid are mixed by a certain proportion to make the ITO etching solution, with PH value as 1-3. The etching temperature is set as 40-50°C. Dimethylsulfoxide and cholamine are mixed under a proportion of 70%:30% to make the liquid to release the photoresist, with release temperature of 40-80°C.

### Formation of first insulation layer:

Coat a layer of negative photoresist on the ITO-coated transparent substrate, with even thickness of 0.5µm~3µm; the negative photresist materials are mainly made up of propylene glyool monomethyl ether acetate, acryl resin, epoxy resin and negative light-sensitive agent. The photoresist can be coated to the substrate by roll coating, spin coating, blade coating or other ways.

After the above processes, the photoresist will be pre-baked, exposed and developed, and finally the regularly patterned insulation layer with thickness of 0.5~3µm will be formed. In forming layer, the pre-baking temperature is set as 60-150 °C, time as 50-200 seconds and exposure energy as 100-500mj. Na series or Ka series alkaline solution is used as developer, and developing temperature is set as 20-40 °C. Then the insulation layer is hard baked under the temperature of 200-300 °Cand for 0.5-3 hours. After the above processes, insulation layer 1 with regular pattern and thickness of 0.5µm~3µm will be finally formed.

### Formation of ITO electrode layer:

Coat a transparent ITO film on the transparent substrate with first insulation layer, with even thickness of 50-2000ANG (surface resistance 10-430 ohm); the said ITO electrode is made of In₂O₃ and SnO₂, whose mass ratio is 85∼95:5∼15. ITO coating can be performed through the means below: vacuum magnetic-enhanced sputtering, chemical vapor phase depositing, thermal evaporating and sol-gel method.

Coat a layer of positive photoresist on the ITO-coated transparent substrate, with even thickness of 1µm~5µm; the said positive photresist materials are mainly made up of propylene glyool monomethyl ether acetate, epoxy resin and positive light-sensitive material. The photoresist can be coated to the substrate by roll coating, spin coating, blade coating or other ways.

After the above processes, the photoresist will be pre-baked, exposed, developed, etched and released, and finally a 50-2000ANG-thick layer of photoresist (surface resistance 10-430ohm) and the regular ITO pattern or electrode will be formed. In forming the layer, the pre-baking temperature is set as 60-150 °C, time as 50-200 seconds and exposure energy as 100-500mj. Na series or Ka series alkaline solution is used as developer, and the developing temperature is set as 20-40 °C. Hydrochloric acid and nitric acid are mixed by a certain proportion to make the ITO etching solution, with PH value as 1-3. The etching temperature is set as 40-50°C. Dimethylsulfoxide and cholamine are mixed under a proportion of 70%:30% to make the liquid to release the photoresist, with release temperature of 40-80°C.

The said ITO electrode consists of capacitive screen driver (ITO electrode 1) and inductive electrode (ITO electrode 2), with regularly patterned structure. ITO electrode 1 and 2 are vertically designed on the same layer, but mutually independent and insulative.

### Formation of metal electrode layer:

Coat a metal film on the transparent substrate with ITO electrode layer, with even thickness of 500-4000ANG. The coated metal film is sandwich structured with stacked MoNb, AlNd and MoNb, whose thickness is respectively arranged as 50-500ANG: 500-3000ANG:50-500ANG. In MoNb alloy, the mass ratio of Mo and Nb is 85∼95:5∼15, while in AlNd alloy, the mass ratio of Al and Nd is 95∼98:2∼5. The metal material can also be silver alloy or copper alloy compounded under a certain proportion. The process of vacuum magnetic-enhanced sputtering is employed here to make the metal film.

Coat a layer of positive photoresist on the metal-filmed transparent substrate, with even thickness of 1µm∼5µm; the said positive photresist materials are mainly made up of propylene glyool monomethyl ether acetate, epoxy resin and positive light-sensitive material. The photoresist can be coated to the substrate by roll coating, spin coating, blade coating or other ways. After the above processes, the photoresist will be pre-baked, exposed, developed, etched and released, and finally a 500-4000ANG-thick layer of photoresist (surface resistance 10-430ohm) and the regular ITO pattern or electrode will be formed. In forming the layer, the pre-baking temperature is set as 60-150 °C, time as 50-200 seconds and exposure energy as 100-500mj. Na series or Ka series alkaline solution is used as developer, and the developing temperature is set as 20-40 °C. Phosphoric acid, acetic acid and nitric acid are mixed by a certain proportion to make the metal etching solution. The etching temperature is set as 40-50°C. Dimethylsulfoxide and cholamine are mixed under a proportion of 70%:30% to make the liquid to release the photoresist, with release temperature of 40-80°C.

The wiring of the said metal electrode is only arranged in the black resin section, and no metal electrode is set in the window section.

### Formation of second insulation layer:

Coat a layer of negative photoresist on the metal-coated transparent substrate, with even thickness of 0.5µm∼3µm;; the negative photresist materials are mainly made up of propylene glyool monomethyl ether acetate, acryl resin, epoxy resin and negative light-sensitive agent (POC A46 made by Taiwan Daxing Co.). The photoresist can be coated to the substrate by roll coating, spin coating, blade coating or other ways.

After the above processes, the photoresist will be pre-baked, exposed and developed, and finally the regularly patterned insulation layer with thickness of 0.5~3µm will be formed. In forming layer, the pre-baking temperature is set as 60-150 °C, time as 50-200 seconds and exposure energy as 100-500mj. Na series or Ka series alkaline solution is used as developer, and developing temperature is set as 20-40 °C. Then the insulation layer is hard baked under the temperature of 200-300 °Cand for 0.5-3 hours. After the above processes, insulation layer 1 with regular pattern and thickness of 0.5µm∼3µm will be finally formed.

With the upgrading of consumers' taste, in the case of electronic products, more emphasis is shifted to their quality. For single-body touch screen, consumers all the more stress its high tranmittance, low reflectivity, invisibility of ITO pattern and high reliability. Thus higher requirements are proposed to us in designing the single-body touch screen.

In the present invention, due to the adoption of SiO₂ and Nb₂O₅, which are properly arranged on the substrate to make an optimized thickness, the touch screen remarkably raises its transmittance and lowers the visuality of the pattern. Especially, when the thickness of SiO₂ is set as 100-1000ANG and Nb₂O₅ as 50-500ANG, the transmittance of the product can be maintained as 93% or higher, and visuality controlled within Class 2, claiming a perfect effect. (Visuality classes are defined as follows: Class 0: completely unseen; Class 10: obviously seen. The higher the class is, the higher the visuality will be)

SiO₂ features its anti-reflection and background-pattern reduction functions. For lights with different polarization states offer phases and amplitudes when reflected on film and air different from those when on film and lining interface, SiO₂ can change the polarization state, lower product reflectivity and reduce visuality of pattern after film reflection. With the increase of the SiO₂ film, some anti-reflection effect can be produced due to the film's interference. Ordinary glass can offer a reflectivity of about 5%, while glass coated with SiO₂ can offer a reflectivity of about 2%. People's naked eyes can obviously see the ITO pattern on the glass with such pattern from a viewing angle, but can't obviously see the ITO pattern on SiO₂-coated glass with such pattern.

If the films are laminated in the following order-black resin, SiO₂and Nb₂O₅, the manufacturing process can be adjusted as:
Formation of black-resin film: Coat the black resin on the transparent substrate through spin or blade process, with even thickness of 0.3µm∼5µm, and pre-bake, expose and develop the resin to form the black-resin section;
Formation of silica layer: Coat SiO₂ on the black resin film to form a transparent silica layer, with even thickness of 100-1000ANG;
Formation of Nb₂O₅ layer: Coat Nb₂O₅ on the silica layer to form a transparent Nb₂O₅ layer, with even thickness of 50-500ANG;
Not many changes are needed for other processes.

The above descriptions constitute further information provided with reference with the detailed execution scheme of the present invention, but it shall not be considered that the execution of the present invention be limited to these contents. For regular technical personnel in the field of the invention, inductions or replacements are deemed to be within the protected scope of the present invention, so long as they don't break away from original conception.

## Claims

1. A novel ITO crossover integrated capacitive touch screen, whereas, includes the transparent substrate, and the silica layer, niobium pentoxide layer, black resin layer, ITO crossover electrode, first insulation layer, ITO electrode, metal electrode and second insulation layer that are sequentially laminated on the transparent substrate. The said ITO electrode consists of ITO electrode 1ITO electrode 2, with regularly patterned structure. ITO electrode 1 and 2 are vertically designed on the same layer, but mutually independent and insulative. The said transparent substrate comprises of window section and non-window section, with the black resin arranged in the non-window section of the display screen. The said silica layer is 100-1000 ANG in thickness, while niobium pentoxide layer is 50-500 ANG.

2. A novel ITO crossover integrated capacitive touch screen, whereas, includes the transparent substrate, and the black resin layer, silica layer, niobium pentoxide layer, ITO crossover electrode, first insulation layer, ITO electrode, metal electrode and second insulation layer that are sequentially laminated on the transparent substrate. The said ITO electrode consists of ITO electrode 1 and ITO electrode 2, with regularly patterned structure. ITO electrode 1 and 2 are vertically designed on the same layer, but mutually independent and insulative. The said transparent substrate comprises of window section and non-window section, while the black resin distributed in the non-window section of the display screen. The said silica layer is 100-1000 ANG in thickness, while niobium pentoxide layer is 50-500 ANG.

3. As claim 1 or claim 2 said touch screen , whereas, the said transparent substrate is made of chemically tempered glass, or resin, with thickness of 0.5-2.0mm, and the said ITO electrode is structured as regularly patterned rhombus, bar, square, or cross.

4. As claim3 said touch screen , whereas, The said black resin layer is 0.3µm ∼ 5µm in thickness, the ITO crossover electrode layer is 50-2000 ANG in thickness ,the first insulation layer is 0.5 ∼ 3µm in thickness, the ITO electrode layer is 50-2000 ANG in thickness, the metal electrode layer is 500-2000 ANG in thickness, the second insulation layer is 0.5 ∼ 3µm in thickness.

5. As claim 4 said touch screen ,whereas, the said coated metal film is sandwich structured with stacked MoNb, AlNd and MoNb, whose thickness is respectively arranged as 50-500ANG: 500-3000ANG:50-500ANG. In MoNb alloy, the mass ratio of Mo and Nb is 85∼95:5∼15, while in AlNd alloy, the mass ratio of Al and Nd is 95∼98:2∼5.

6. As claim 5 said touch screen , whereas, the said ITO layer including In2O3 and SnO₂, the mass ratio is 95∼98:2∼5.

7. A manufacturing method of the novel ITO crossover integrated capacitive touch screen, including:
Formation of silica layer: Coat the transparent substrate with SiO₂ to form a transparent SiO₂ film with even thickness of 100-1000 ANG;
Formation of niobium pentoxide layer: Coat the silica layer with Nb₂O₅ to form a transparent Nb₂O₅ film with even thickness of 50-500 ANG;
Formation of black resin layer: First the black resin is evenly spread to the transparent substrate by spin-coating or blade-coating, with thickness of 0.3µm~5µm. Then the resin is pre-baked, exposed and developed to create the needed black-resin section. The black-resin section is structured as trapezoid, with thickness of 0.3µm~5µm in its middle and a bevel angle of 6-60 degrees at the edge. Such a gentle angle is designed in an attempt to prevent the ITO electrode from breaking in the case of the sharp thickness difference appearing when ITO electrodes (drive wire ITO electrode 1 and induction wire ITO electrode 2) pass by the slope. The black resin area serves as the non-window section of the display screen to shade the metal electrode. The said black resin is made of protective light-sensitive photoresist (KE410 made by Taiwan Everlight Chemical). As a black negative photoresist, the material mainly consists of: acryl resin, epoxy resin, negative light-sensitive agent, propylene glyool monomethyl ether acetate(PMA) and black pigment, the actual ratio of which are as follows: 15∼30(resin):60∼80(PMA):1∼10(black pigment and negative light-sensitive agent);
Formation of ITO crossover electrode: Use ITO to coat the black resin-coated transparent substrate and make a transparent ITO film with even thickness of 50-2000ANG on the substrate;
Coat a layer of positive photoresist on the ITO-coated transparent substrate, with even thickness of 1µm∼5µm;
After the photoresist is pre-baked, exposed, developed, etched and released, and finally a 50-200ANG-thick layer of photoresist and the regular ITO pattern or electrode will be formed;
The said ITO crossover electrodes include the crossover electrode in the display screen and overlapping electrode at the edge of the black-resin layer, both of which have regularly patterned structure, and are designed on the same layer and mutually independent and insulative.
Formation of first insulation layer:
Coat a layer of negative photoresist on the ITO-coated transparent substrate, with even thickness of 0.5µm~3µm;
After the photoresist is pre-baked, exposed and developed, the insulation layer pattern with thickness of 0.5~3µm will be formed;
Formation of ITO electrode layer:
Coat a transparent ITO film on the transparent substrate with first insulation layer, with even thickness of 50-2000ANG (surface resistance 10-430 ohm);
Coat a layer of positive photoresist on the ITO-coated transparent substrate, with even thickness of 1µm~5µm;
After the photoresist is pre-baked, exposed, developed, etched and released, and finally a 50-200ANG-thick layer of photoresist (surface resistance 10-430ohm) and the regular ITO pattern or electrode will be formed.
The said ITO electrodes includes the driver (ITO electrode 1) in the capacitive screen and induction electrode (ITO electrode 2), both of which have regularly patterned structure, and are vertically designed on the same layer and mutually independent and insulative.
Formation of metal electrode layer:
Coat a metal film on the transparent substrate with ITO electrode layer, with even thickness of 500-4000ANG;
Coat a layer of positive photoresist on the metal-coated transparent substrate, with even thickness of 1µm~5µm;
After the photoresist is pre-baked, exposed, developed, etched and released, and finally a 500-4000ANG-thick layer of photoresist (surface resistance 10-430ohm) and the regular ITO pattern or electrode will be formed;
Formation of second insulation layer:
Coat a layer of negative photoresist on the metal-coated transparent substrate, with even thickness of 0.5µm~3µm;
After the photoresist is pre-baked, exposed and developed, the insulation layer pattern with thickness of 0.5~3µm will be formed.

8. A manufacturing method of the novel ITO crossover integrated capacitive touch screen, including:
Formation of black resin layer: First the black resin is evenly spread to the transparent substrate by spin-coating or blade-coating, with thickness of 0.3µm~5µm. Then the resin is pre-baked, exposed and developed to create the needed black-resin section. The black-resin section is structured as trapezoid, with thickness of 0.3µm~5µm in its middle and a bevel angle of 6-60 degrees at the edge. Such a gentle angle is designed in an attempt to prevent the ITO electrode from breaking in the case of the sharp thickness difference appearing when ITO electrodes (drive wire ITO electrode 1 and induction wire ITO electrode 2) pass by the slope. The black resin area serves as the non-window section of the display screen to shade the metal electrode. The said black resin is made of protective light-sensitive photoresist (KE410 made by Taiwan Everlight Chemical). As a black negative photoresist, the material mainly consists of: acryl resin, epoxy resin, negative light-sensitive agent, propylene glyool monomethyl ether acetate(PMA) and black pigment, the actual ratio of which are as follows: 15∼30(resin):60∼80(PMA):1∼10(black pigment and negative light-sensitive agent);
Formation of silica layer: Coat the transparent substrate with SiO₂ to form a transparent SiO₂ film with even thickness of 100-1000 ANG;
Formation of niobium pentoxide layer: Coat the silica layer with Nb₂O₅ to form a transparent Nb₂O₅ film with even thickness of 50-500 ANG;
Formation of ITO crossover electrode: Use ITO to coat the black resin-coated transparent substrate and make a transparent ITO film with even thickness of 50-2000ANG on the substrate;
Coat a layer of positive photoresist on the ITO-coated transparent substrate, with even thickness of 1µm∼5µm;
After the photoresist is pre-baked, exposed, developed, etched and released, and finally a 50-200ANG-thick layer of photoresist and the regular ITO pattern or electrode will be formed;
The said ITO crossover electrodes include the crossover electrode in the display screen and overlapping electrode at the edge of the black-resin layer, both of which have regularly patterned structure, and are designed on the same layer and mutually independent and insulative.
Formation of first insulation layer:
Coat a layer of negative photoresist on the ITO-coated transparent substrate, with even thickness of 0.5µm~3µm;
After the photoresist is pre-baked, exposed and developed, the insulation layer pattern with thickness of 0.5~3µm will be formed;
Formation of ITO electrode layer:
Coat a transparent ITO film on the transparent substrate with first insulation layer, with even thickness of 50-2000ANG (surface resistance 10-430 ohm);
Coat a layer of positive photoresist on the ITO-coated transparent substrate, with even thickness of 1µm~5µm;
After the photoresist is pre-baked, exposed, developed, etched and released, and finally a 50-200ANG-thick layer of photoresist (surface resistance 10-430ohm) and the regular ITO pattern or electrode will be formed.
The said ITO electrodes includes the driver (ITO electrode 1) in the capacitive screen and induction electrode (ITO electrode 2), both of which have regularly patterned structure, and are vertically designed on the same layer and mutually independent and
insulative.
Formation of metal electrode layer:
Coat a metal film on the transparent substrate with ITO electrode layer, with even thickness of 500-4000ANG;
Coat a layer of positive photoresist on the metal-coated transparent substrate, with even thickness of 1µm∼5µm;
After the photoresist is pre-baked, exposed, developed, etched and released, and finally a 500-4000ANG-thick layer of photoresist (surface resistance 10-430ohm) and the regular ITO pattern or electrode will be formed;
Formation of second insulation layer:
Coat a layer of negative photoresist on the metal-coated transparent substrate, with even thickness of 0.5µm∼3µm;
After the photoresist is pre-baked, exposed and developed, the insulation layer pattern with thickness of 0.5∼3µm will be formed.

9. As claim 7 or 8 said manufacturing method, whereas, the said transparent substrate is made of chemically tempered glass, with thickness of 0.5-2.0mm, and the said ITO electrode includes In₂O₃ and SnO₂, whose mass ratio is 85∼95:5∼15.

10. As claim 9 said manufacturing method, whereas, the said positive photresist materials are mainly made up of propylene glyool monomethyl ether acetate, epoxy resin and positive light-sensitive agent; the negative photresist materials are mainly made up of propylene glyool monomethyl ether acetate, acryl resin, epoxy resin and negative light-sensitive agent ; the coated metal film is sandwich structured with stacked MoNb, AlNd and MoNb, whose thickness is respectively arranged as 50-500ANG: 500-3000ANG:50-500ANG. In MoNb alloy, the mass ratio of Mo and Nb is 85∼95:5∼15, while in AlNd alloy, the mass ratio of Al and Nd is 95∼98:2∼5; the process of vacuum magnetic-enhanced sputtering is employed here to make the metal film.
